# EUROPEAN PATENT APPLICATION

(11) **EP 2 256 602 A2**
(43) Date of publication of application: **01.12.2010**
(21) Application number: 10162604.2
(22) Date of filing: 11.05.2010
(51) Int. Cl.: G06F 3/044, H03K 17/96

(54) **Capacitive touch panel having a non-planar touch surface**

(30) Priority: 29.05.2009 US 474295
(71) Applicant: Delphi Technologies, Inc., Troy, MI 48007 (US)
(72) Inventor: Netherton, Steven V., Tipton, IN 46072 (US); Gill, Mark A., Russiaville, IN 46979 (US)
(74) Representative: Denton, Michael John

(57) **Abstract**

An improved capacitive touch panel (30/50) includes a trimplate (32/52) defming a non-planar touch surface (24), a planar array of capacitive sensing elements (40) mounted behind the trimplate (32/52), and a formable interface element (36/54) of high relative static permittivity sandwiched between the sensing elements (40) and the inboard face (32a) of the trimplate (32/54). The interface element (36/54) is a compression molded silicone rubber element having a first major surface (44) that is sculpted to match and uniformly contact the inboard face (32a) of the trimplate (32/54), and a second major surface (42/82) that is planar and uniformly contacts the planar array of capacitive sensing elements (40). The interface element (36/54) has a limited amount of compliance so that slight compression of the interface element (36/54) between the trimplate (32/54) and sensing elements (40) eliminates any air gaps between the contacting surfaces.

## Description

### TECHNICAL FIELD

The present invention relates to a touch panel including a capacitive proximity sensor that detects a finger touch on the panel based on a change in the sensor's fringing capacitance, and more particularly to touch panel having a non-planar touch surface.

### BACKGROUND OF THE INVENTION

Touch panels utilizing projected capacitance to detect a person's finger touch have been employed as a user interface in many consumer electronic products. The touch surface is the outboard face of a trimplate constructed of a dielectric material such as glass or plastic, and a capacitive sensor having an array of sensing nodes is located behind the trimplate. Each sensing node essentially comprises a pair of closely spaced conductive plates that are maintained at different electric potentials to establish a fringing electric field between them. When the user's finger touches the trimplate opposite a sensing node, the intensity of the fringing electric field changes due to capacitive coupling between the finger and each of the conductive plates, and a circuit detects the finger touch as a change in capacitance between the conductive plates.

For best results, the distance between the touch surface and the array of capacitive sensing nodes should be substantially constant. This can be achieved at relatively low cost by using a planar trimplate and forming the sensing nodes, detection circuitry and other electronics on a planar circuit board that is mounted parallel to trimplate. In some cases, however, styling considerations require the use of a non-planar trimplate having a curved touch surface, resulting in undesired variation in distance between the touch surface and the sensing nodes formed on the planar circuit board. The usual approach in such cases is to form the sensing nodes on a flexible film and laminate the flexible film to the inboard face of the trimplate. This approach can be used effectively if the curvature is simple and gentle, but still results in higher overall cost because a separate circuit board must be provided for the detection circuitry, displays and so forth. And if the curvature of the trimplate is complex and/or severe, it becomes increasingly difficult to reliably laminate a flexible sensing film to its inboard face without incurring wrinkles and air pockets. Accordingly, what is needed is an improved and low-cost way of producing a capacitive touch panel having a non-planar touch surface.

### SUMMARY OF THE INVENTION

The present invention is directed to an improved capacitive touch panel including a trimplate defining a non-planar touch surface, a planar array of capacitive sensing elements mounted behind the trimplate, and a formable interface element of high relative static permittivity sandwiched between the sensing elements and the inboard face of the trimplate. Preferably, the interface element is a compression molded silicone rubber element having a first major surface that is sculpted to match and uniformly contact the inboard face of the trimplate, and a second major surface that is planar for uniformly contacting the planar array of capacitive sensing elements. The interface element may also have a limited amount of compliance so that mildly compressing the interface element between the trimplate and sensing elements eliminates any air gaps between the contacting surfaces.

### BRIEF DESCRIPTION OF THE DRAWINGS

FIGS. 1A and 1B conceptually depict a capacitive sensing element formed on a planar circuit board. FIG. 1A is a cross-sectional view, and FIG. 1B is a top view.

FIGS. 2A, 2B and 2C depict a curved capacitive touch panel for an audio component according to a first embodiment of this invention. FIG. 2A is a front view of the touch panel, FIG. 2B is a cross-sectional view along lines (2B-2B) of FIG. 2A, and FIG. 2C is a cross-sectional view along lines (2C-2C) of FIG. 2A.

FIG. 3 is an exploded isometric view of the curved capacitive touch panel of FIGS. 2A-2C.

FIG. 4 is an exploded isometric view of curved capacitive touch panel for an audio component according to a second embodiment of this invention.

### DESCRIPTION OF THE PREFERRED EMBODIMENT

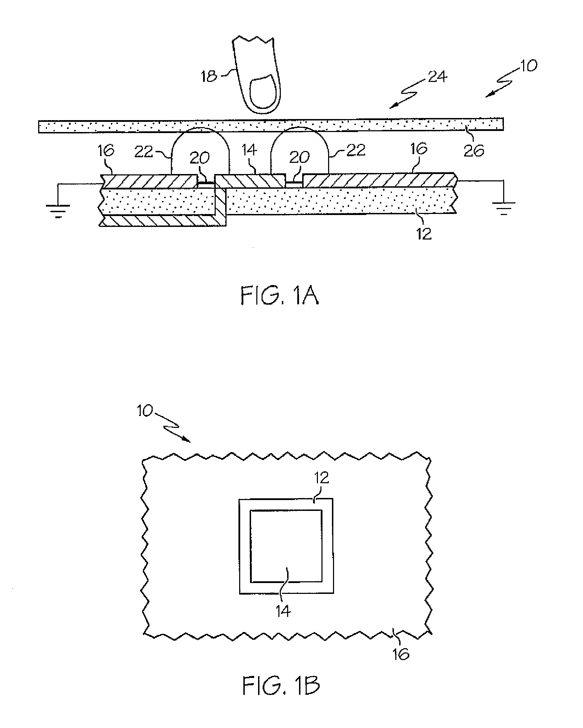

FIGS. 1A and 1B illustrate a planar implementation of a capacitive sensing element 10 for a touch panel application. In the illustrated configuration, the sensing element or node is defined by a pair of conductive plates formed on the surface of a circuit board 12, one plate being defined by a small rectangular conductor 14, and the other being defined by a ground plane conductor 16 that surrounds but does not touch the small conductor 14. A detection circuit (not shown) is responsive to the electrical capacitance between the conductors 14 and 16, and detects a change in capacitance that occurs when a human finger 18 comes in proximity to the sensing element 10. In general, there is a direct capacitance between conductors 14 and 16 associated with the electric field lines 20, and a fringing capacitance associated with the fringing electric field lines 22. The capacitances are in parallel so that the measured capacitance is effectively their sum. When finger 18 touches the surface 24 of a dielectric trimplate 26, the fringing capacitances are altered due to capacitive coupling between the finger 18 and the conductors 14 and 16, and the detection circuit senses the finger touch as a change in the measured capacitance.

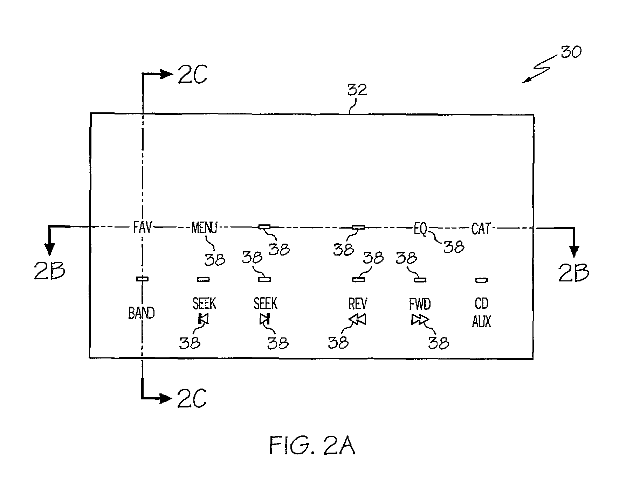

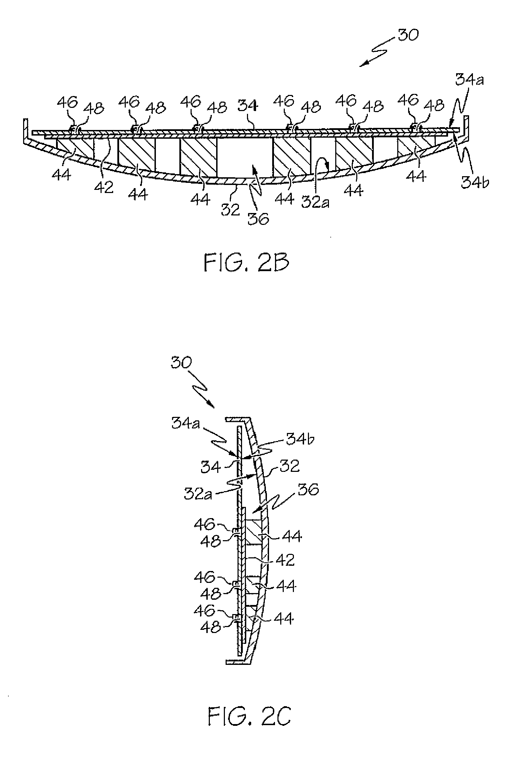

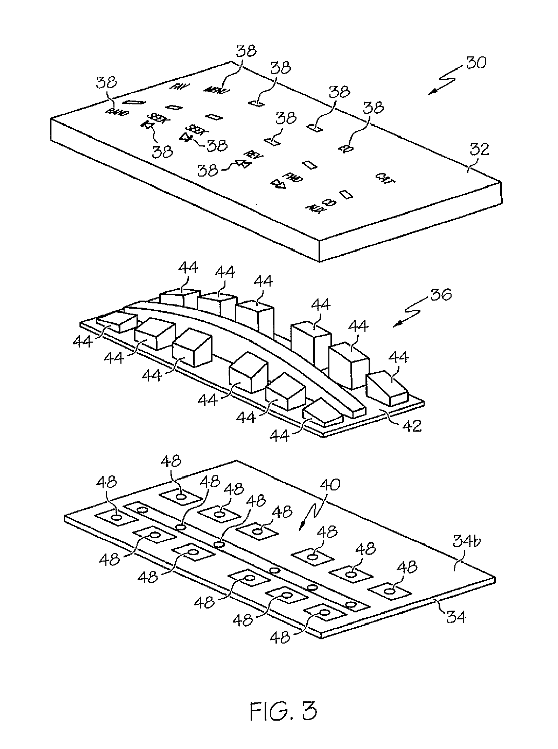

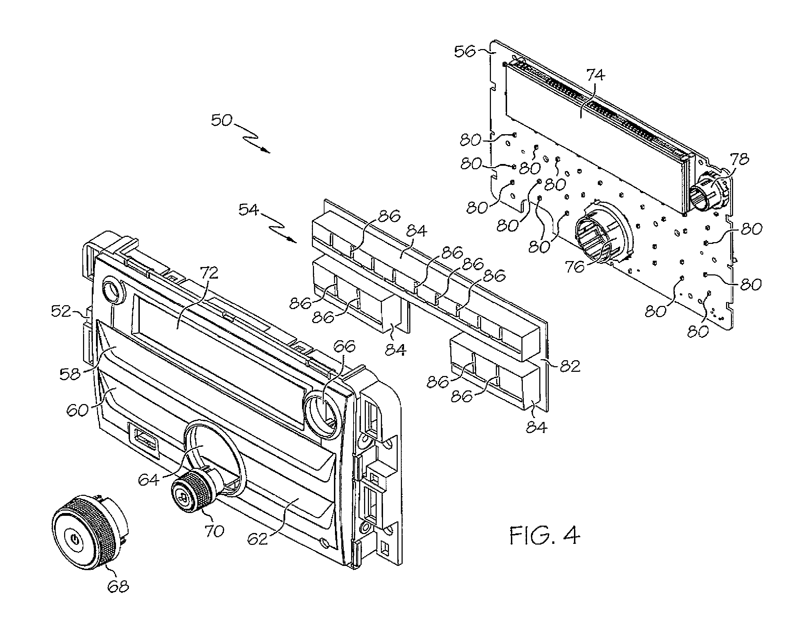

While the illustration of FIGS. 1A-1B assumes the use of a planar trimplate 26, styling considerations sometimes require the use of a non-planar trimplate having a curved touch surface 24. This of course results in a variable length air gap between the touch surface 24 and the planar array of capacitive sensing elements 10, and consequent problems with detection reliability. This problem is addressed according to the present invention by interposing a suitably sculpted high relative static permittivity material between the touch panel and the planar array of capacitive sensing elements. A first embodiment of the invention is depicted in FIGS. 2A-2C and 3, and a second embodiment is depicted in FIG. 4.

Referring to FIGS. 2A-2C and 3, the reference numeral 30 generally designates a capacitive touch panel for an automotive or consumer electronic product such as an audio system. The panel 30 includes a curved trimplate 32, a populated circuit board 34, and a silicone interface element 36. The trimplate 32 is constructed of a translucent material, the outboard face of which is painted and then selectively laser-etched to form an array of graphic indicia 38 that designate user touch points for selecting various audio functions. The circuit board 34 is mounted behind the trimplate 32 and, as best seen in FIG. 3, supports an array of capacitive sensing nodes 40 in alignment with the graphic indicia 38 on trimplate 32. The silicone interface element 36, disposed between the circuit board 34 and trimplate 32, includes a planar base 42 that uniformly contacts the inboard face of circuit board 34, and a set of integral towers or pedestals 44 that extend toward and uniformly contact the inboard face 32a of trimplate 32.

The ends of the silicone towers 44 are contoured to match the local curvature of the trimplate 32 as shown so that the towers 44 fully and uniformly contact the inboard face 32a of trimplate 32 with only a small amount of force biasing the trimplate 32 toward the circuit board 34 (which force may be provided simply by mounting the circuit board 34 in the audio component). Thus, each touch point on the exposed face of trimplate 32 is coupled by a silicone tower 44 to a capacitive sensing node formed on circuit board 34. For each touch point, the respective silicone tower 44 provides a high relative static permittivity for concentrating the electrostatic lines of flux between each touch point and a respective capacitive sensing node. As a result, the capacitive sensing nodes reliably detect finger touches at the various touch points even though the distances between the circuit board 34 and the touch points vary substantially due to the trimplate curvature. Additionally, the silicone interface element 36 is compliant so that by gently compressing the interface element 36 between the trimplate 32 and sensing elements 40 eliminates any air gaps between the contacting surfaces.

Another advantageous aspect of the silicone interface element 36 is that it conducts light, allowing the graphic indicia 38 to be backlit by an array of LEDs 46 mounted on circuit board 34. In the illustrated embodiment, the LEDs 46 are mounted on the outboard face 34a of circuit board 34 as shown in FIGS. 2B-2C, opposite respective circuit board openings 48 that direct the emitted light into the respective silicone towers 44. Mounting the LEDs 46 on the outboard face 34a of circuit board 34 preserves the planarity of the inboard face 34b so that the base 42 of silicone interface element 36 fully and uniformly engages the inboard face 34b for optimal coupling between the touch points on trimplate 32 and the corresponding capacitive sensing nodes 40 formed on circuit board 34. The silicone towers 44 not only conduct, but also diffuse, the light emitted by the LEDs 46, so no other light-modifying filters or lenses are needed.

FIG. 4 depicts another capacitive touch panel 50 for an automotive or consumer electronic product such as an audio system, including a trimplate 52, a silicone interface element 54 and a planar circuit board 56. In this case, the trimplate 52 incorporates a set of three finger guides 58, 60, 62 with graphic indicia (not shown), openings 64, 66 for receiving a pair of knobs 68, 70, and a lens 72 through which a user views a display 74. The circuit board 56 supports the display 74, potentiometers 76, 78 for receiving the knobs 68, 70, and an array of capacitive sensing nodes aligned with the finger guides 58, 60, 62. The capacitive sensing nodes are not explicitly depicted in FIG. 4, but their locations are identified by the openings 80 that pass light emitted from an array of rear-mounted LEDs (not shown). The silicone interface element 54 corresponds in outline to the three finger guides 58, 60, 62, and like the embodiment of FIGS. 2A-2C and 3, includes a planar base 82 that uniformly contacts the circuit board 56, and a set of towers 84 extending from base 82 toward the trimplate 52. Also, the ends of the towers 84 are sculpted to match the inboard face of the trimplate 52 so that they uniformly contact the trimplate surface when the touch panel 50 is assembled. In this case, however, the towers 84 are relatively extensive in width, and are effectively subdivided by the recesses 86 to define a single tower for each of the touch points on finger guides 58, 60, 62. Advantageously, the recesses 86 also provide pathways to channel away any air trapped between the towers 84 and the inboard face of trimplate 52. Thus, relative to the embodiment of FIGS. 2A-2C and 3, the embodiment of FIG. 4 illustrates both an alternate construction of the silicone interface element, and a circuit board 56 that supports other elements (display 74 and potentiometers 76, 78) in addition to the array of capacitive sensing nodes.

In summary, the present invention provides an improved and low-cost way of producing a capacitive touch panel having a non-planar touch surface through the use of a silicone interface element that propagates static electric fields between the non-planar touch surface and a planar capacitive sensor array. While the present invention has been described with respect to the illustrated embodiment, it is recognized that numerous modifications and variations in addition to those mentioned herein will occur to those skilled in the art. For example, the invention can be used with any number of sensing elements, and so forth. Accordingly, it is intended that the invention not be limited to the disclosed embodiment, but that it have the full scope permitted by the language of the following claims.

## Claims

1. A capacitive touch panel (10/50), comprising:
a planar circuit board (34/56) supporting an array of capacitive sensing elements (40);
a trimplate (32/52) spaced apart from said planar circuit board (34/56), and defining a non-planar touch surface (24) with an array of touch points (38) in alignment with the array of capacitive sensing elements (40), the various touch points (38) being separated from respective capacitive sensing elements (40) by different distances due to the non-planarity of the touch surface (24) and the planarity of the circuit board (34/56); and
a silicone interface element (36/54) sandwiched between said planar circuit board (34/56) and said trimplate (32/52) for electrically coupling the touch points (38) to the respective capacitive sensing elements (40) to compensate for the different distances.

2. The capacitive touch panel of claim 1, where:
said silicone interface element (36/54) includes a planar base (42/82) that uniformly contacts an inboard face (34b) of said planar circuit board (34/56), and an array of towers (44/84) that extend from said planar base (42/82) and uniformly contact an inboard face (32a) of said trimplate (32/52) in alignment with said array of touch points (38).

3. The capacitive touch panel of claim 2, where:
the towers (44/84) of said silicone interface element (36/54) have ends that are sculpted to match and uniformly contact the inboard face (32a) of said trimplate (32/52).

4. The capacitive touch panel of claim 2, where:
said touch points (38) and the towers (44/84) of said silicone interface element (36/54) are both light transmissive; and
said circuit board (34/56) supports an array of light emitting devices (46) that direct light through said towers (44/84) and said touch points (38) to backlight said touch points (38).

5. The capacitive touch panel of claim 4, where:
said light emitting devices (46) are mounted on an outboard face (34a) of said circuit board (34/56) to preserve the planarity of said inboard face (34b); and
said circuit board (34/56) includes openings (48) that pass light emitted by said light emitting devices (46) into said towers (44/84) and said touch points (38).

6. The capacitive touch panel of claim 2, where:
said array of towers (84) are defined by recesses (86) formed in a block of silicone material that extends from said base (82).

7. The capacitive touch panel of claim 1, where:
said silicone interface element (36/54) is **characterized by** both compliance and a high relative static permittivity.
